# EUROPÄISCHE PATENTSCHRIFT

(11) **EP 1 476 938 B1**
(45) Veröffentlichungstag und Bekanntmachung des Hinweises auf die Patenterteilung: **23.05.2012**
(21) Anmeldenummer: 02798263.6
(22) Anmeldetag: 06.12.2002
(51) Int. Cl.: H03B 9/14

(54) **VORRICHTUNG ZUM ERZEUGEN VON SCHWINGUNGEN IM HOCHFREQUENZ-BEREICH**
DEVICE GENERATING OSCILLATIONS IN THE HIGH-FREQUENCY RANGE
DISPOSITIF POUR GENERER DES ONDES DANS LA ZONE DE HAUTE FREQUENCE

(30) Priorität: 08.02.2002 DE 10205183
(43) Veröffentlichungstag der Anmeldung: 17.11.2004
(73) Patentinhaber: ROBERT BOSCH GMBH, 70442 Stuttgart (DE)
(72) Erfinder: MAYER, Hermann, 71665 Vaihingen (DE); KOERBER, Sabine, 71638 Ludwigsburg (DE); LUCAS, Bernhard, 74354 Besigheim (DE); NOETHEN, Norbert, 72768 Reutlingen (DE); SEIZ, Juergen, 73642 Welzheim (DE); STEUDE, Guido, 72770 Reutlingen (DE); KUGLER, Andreas, 73553 Alfdorf (DE)
(86) Internationale Anmeldenummer: PCT/DE2002/004472
(87) Internationale Veröffentlichungsnummer: WO 2003/067750

(56) Entgegenhaltungen:
- EP-A- 1 047 183
- WO-A-99/03002
- WO-A-02/075916
- US-A- 4 222 014
- US-A- 5 126 696
- US-A1- 2002 093 386
- US-B1- 6 218 916
- LAN G L ET AL: "A W-band channelized monolithic receiver" IEEE MICROWAVE AND MILLIMETER-WAVE MONOLITHIC CIRCUITS SYMPOSIUM, 1989, 12. Juni 1989 (1989-06-12), Seiten 95-99, XP010087280
- "W-BAND VARACTOR-TUNED OSCILLATORS WITH 10 GHZ BANDWIDTH" MICROWAVE JOURNAL, HORIZON HOUSE. DEDHAM, US, Bd. 31, Nr. 10, 1. Oktober 1988 (1988-10-01), Seiten 137-140, XP000024687 ISSN: 0192-6225
- PRIESTLEY N ET AL: "A GUNN DIODE BASED SURFACE MOUNT 77GHZ OSCILLATOR FOR AUTOMOTIVE APPLICATIONS" 2002 IEEE MTT-S INTERNATIONAL MICROWAVE SYMPOSIUM DIGEST.(IMS 2002). SEATTLE, WA, JUNE 2 - 7, 2002, IEEE MTT-S INTERNATIONAL MICROWAVE SYMPOSIUM, NEW YORK, NY: IEEE, US, Bd. 3 OF 3, 2. Juni 2002 (2002-06-02), Seiten 1863-1866, XP001113967 ISBN: 0-7803-7239-5

## Beschreibung

### Technisches Gebiet

Die vorliegende Erfindung betrifft eine Vorrichtung gemäß dem Oberbegriff des Anspruchs 1 (vgl. Druckschrift WO 99/03002 A1 aus dem Stand der Technik; vgl. des Weiteren auch die Druckschrift en US 6 218 916 B1, WO9903002, US5126696 sowie die Veröffentlichung von G. L. LAN et al., "A W-band channelized monolithic receiver", IEEE MICROWAVE AND MILLIMETER-WAVE MONOLITHIC CIRCUITS SYMPOSIUM, 1989, 12. Juni 1989, Seiten 95 bis 99).

### Stand der Technik

Bei H(och)F(requenz)- und Höchstfrequenz-Schaltungen (Frequenz f größer als fünfzig Gigahertz) werden zum Erzeugen der elektromagnetischen Schwingungen Gunn-Elemente eingesetzt. Derartige Gunn-Elemente können jeweils in einem Gehäuse angeordnet sein (vgl. etwa die Druckschrift DE 199 06 205 A1).

Für Anwendungen in Fahrzeug-Radargeräten zur Abstandserkennung und -regelung kommen als H(och)F(requenz)-Quellen hierbei Gunn-Oszillatoren bei beispielsweise 77 Gigahertz zum Einsatz. Diese Gunn-Oszillatoren sind in bekannten Ausgestaltungsformen über eine schraubbare Hohlleiter-Verbindung mit geeigneten Übergängen (sogenannte "Step-Transformer") verbunden, die die hochfrequente Energie in planare Verteilnetzwerke einspeisen. Die Zuführung der Versorgungsgleichspannung erfolgt hierbei über eine im Regelfall handgelötete Kabelverbindung.

Allerdings ist bei dieser Art des Übergangs mindestens eine Flanschverbindung mit Verschraubung und mit Passtiften vorgesehen, wodurch die Vorrichtung aufwendig wird sowie umständlich zu montieren ist; des weiteren muß gemäß dem Stand der Technik die Spannungszuführung separat gelötet werden; schließlich benötigen angeordnete Entstörkondensatoren konventionellerweise eine zusätzliche Leiterplatte.

### Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Vorrichtung der eingangs genannten Art so auszubilden, daß diese auf einfache, kostengünstige und schnelle Art montiert werden kann.

Diese Aufgabe wird durch eine Vorrichtung mit den im Anspruch 1 angegebenen Merkmalen gelöst. Vorteilhafte Ausgestaltungen und zweckmäßige Weiterbildungen der vorliegenden Erfindung sind in den Unteransprüchen gekennzeichnet.

Gemäß der Lehre der vorliegenden Erfindung ist mithin mindestens ein planar bestückbarer oder S(urface)M(ounted)D(evice)-bestückbarer Gunn-Oszillator gemäβ Anspruch 1 vorgesehen (S(urface)M(ounted)D(evice)-Bauelement = oberflächenmontiertes Bauelement), der auf mindestens einer leiterplattenartig ausgebildeten, sich im wesentlichen planar erstreckenden elektrischen oder elektronischen Schaltungsanordnung, insbesondere elektrischen oder elektronischen H(och)F(requenz)-Schaltungsanordnung, montierbar ist.

Es ist besonders vorteilhaft, daß durch eine einfache Montage des Gunn-Oszillators, insbesondere mittels Clip- oder Steckverbindung, die konventionellerweise anzuordnenden Flanschverbindungen einschließlich der Verschraubung und der Passtifte entfallen können. Eine besonders dauerhafte, effiziente und zuverlässige Verbindung zur H(och)F(requenz)-Schaltung kann hierbei über Klebetechnik oder über Löttechnik oder über eine Kombination dieser beiden Techniken erfolgen.

Gemäß einer besonders erfinderischen Weiterbildung der vorliegenden Vorrichtung erfolgt die Spannungszuführung nicht mittels separater Lötung (so wie dies im Stand der Technik der Fall ist), sondern durch mindestens ein integriertes Federteil. Des weiteren ist auch von erfindungswesentlichem Vorteil, daß die Entstörkondensatoren keine Zusatz-Leiterplatte benötigen.

Die vorliegende Erfindung betrifft , schließlich mindestens eine insbesondere als Fahrzeug-Radargerät ausgebildete Einrichtung zum Erkennen und/oder zum adaptiven Regeln des Abstands eines Fortbewegungsmittels in bezug auf mindestens ein Objekt, aufweisend mindestens einer Vorrichtung der vorstehend dargelegten Art.

### Kurze Beschreibung der Zeichnungen

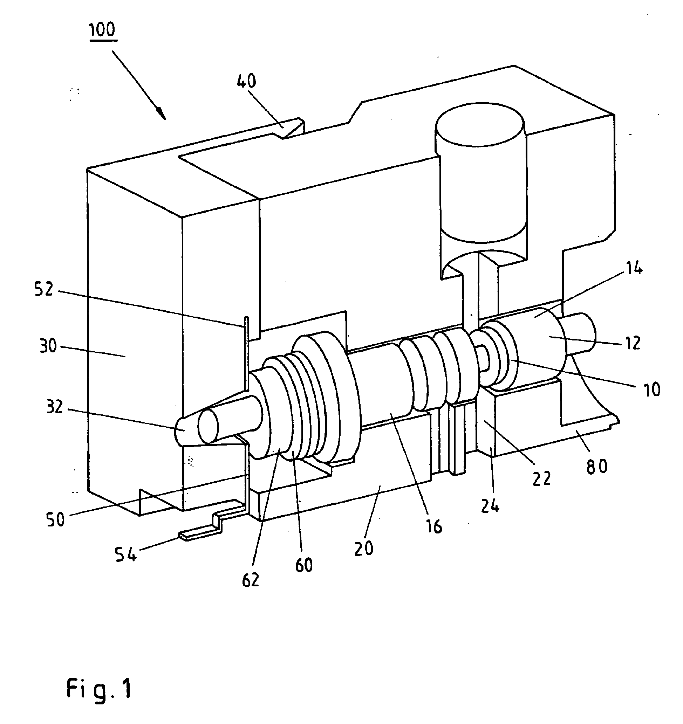

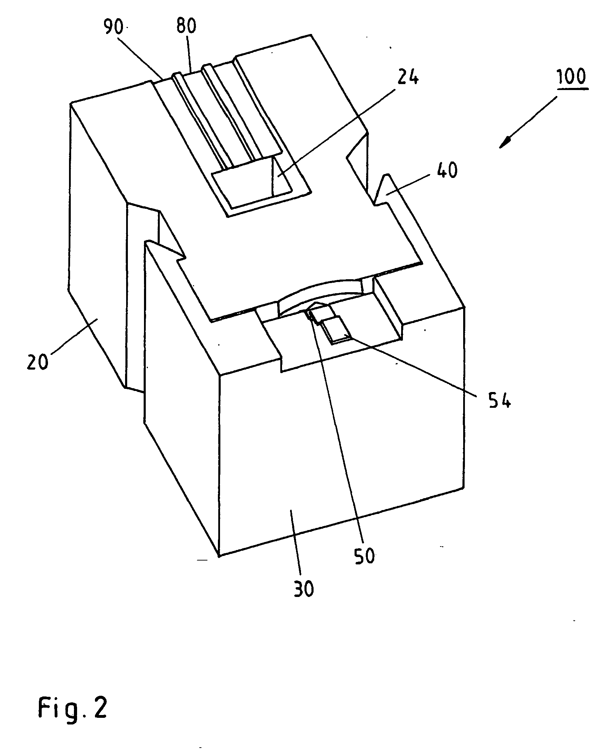

Weitere Ausgestaltungen, Merkmale und Vorteile der vorliegenden Erfindung werden nachstehend anhand des durch die Figuren 1 und 2 veranschaulichten Ausführungsbeispiels näher erläutert.

Es zeigt:
- Fig. 1: eine perspektivische Seitenansicht eines Ausführungsbeispiels einer Vorrichtung gemäß der vorliegenden Erfindung; und
- Fig. 2: eine perspektivische Unteransicht der Vorrichtung aus Fig. 1.

Gleiche oder ähnliche Ausgestaltungen, Elemente oder Merkmale sind in den Figuren 1 und 2 mit identischen Bezugszeichen versehen.

### Bester Weg zur Ausführung der Erfindung

Aus den perspektivischen Darstellungen der Figuren 1 und 2 geht ein sogenannter Gunn-Oszillator, das heißt eine Vorrichtung 100 zum Erzeugen elektromagnetischer Schwingungen im H(och)F(requenz)-Bereich, nämlich im Gigahertzbereich (GHz-Bereich), hervor. Diese Vorrichtung 100 ist Teil einer als Fahrzeug-Radargerät ausgebildeten Einrichtung zum Erkennen und zum adaptiven Regeln des Abstands eines Kraftfahrzeugs.

Im Gegensatz zu den Ausführungsformen gemäß dem Stand der Technik ist in den Figuren 1 und 2 eine Vorrichtung 100 gezeigt, die ähnlich wie ein elektronisches S(urface)M(ounted)D(evice)-Bauelement direkt auf eine leiterplattenartige planare H(och)F(requenz)-Schaltung bestückt werden kann.

Dieser Gun-Oszillator 100 weist einen metallischen Grundkörper 20 in Form eines Oszillatorblocks mit eingebrachtem Rechteck- oder Rund-Hohlleiter 22 auf. In diesen Rechteck- oder Rund-Hohlleiter 22 ragt die eigentliche Gunn-Diode 10, die mit ihrer integrierten Heatsink 12 in eine erste Bohrung 26 des Grundkörpers 20 eingepreßt ist und dort zusätzlich mit einer Verstemmung 14 gegen Ausdrücken gesichert wird.

Gegenüberliegend ist der spannungszuführende sogenannte Bias-Choke 16 in einer weiteren Bohrung 28 des Grundkörpers 20 montiert. Dieser Bias-Choke 16 beinhaltet (wie in an sich bekannten Ausführungsformen auch) eine Resonatorscheibe sowie H(och)F(requenz)-Filterstrukturen.

Seitlich an den Oszillatorblock 20 ist mittels einer Clips-Verbindung 40 ein isolierender Kunststoffkörper 30 angebracht. In diesen Kunststoffkörper 30 ist ein metallisch leitfähiges (Verbindungs-)Element 50 eingebracht, das vorzugsweise direkt beim Herstellen des Kunststoffteils 30 mit eingespritzt wird. Das leitfähige Element 50 weist an seinem einen Ende 52 eine angeformte Federstruktur 60 auf, die eine Kraft auf den Bias-Choke 16 ausübt und derart für die Verbindung des Bias-Choke 16 mit der Gunn-Diode 10 sorgt.

Gleichzeitig wird hierdurch auch eine elektrische Verbindung zwischen dem Federteil 60 und dem Bias-Choke 16 hergestellt. Als Werkstoff eignet sich für das Element 50 eine Kupfer-Beryllium-Legierung, die sowohl gute Federeigenschaften als auch eine gute Leitfähigkeit aufweist.

Anstelle der angeformten Federstruktur 60 ist alternativ auch ein separates Federelement montierbar. Die Gestaltung des federnden Bereichs erfolgt in diesem Zusammenhang derart, daß zwischen der Feder und dem Bias-Choke 16 ein ringförmiges Ferritelement 62 eingebracht werden kann, das zur Unterdrückung von unerwünschten Stromschwingungen der Versorgung benötigt wird.

Das Kunststoffelement 30 weist zudem noch eine insbesondere konische Bohrung 32 auf, in der das Ende des Bias-Choke 16 geführt wird, um eventuelle, während der Montage oder durch Vibration im Fahrzeug-Einsatz hervorgerufene Querkräfte aufzufangen.

Das andere Ende 54 des eingespritzten Metallteils 50 ist vergleichbar einem Anschlußbeinchen eines elektronischen Bauelements ausgeformt und derart dimensioniert, daß die Anschlußfläche 70 des Beinchens eine Ebene mit der Austrittsfläche 24 des Hohlleiters 22 aus dem Oszillatorblock 20 bildet.

Die Austrittsfläche 24 am Oszillatorblock 20 weist weiterhin eine Aussparung 80 auf, die den Durchtritt der H(och)F(requenz)-Leitung auf der planaren Schaltung ermöglicht. Des weiteren sind Nuten 90 zum Auffangen überschüssiger Mengen an Leitkleber oder an Lötmittel vorgesehen.

Abschließend sei auf die erfindungswesentlichen Ausgestaltungen, Merkmale und Vorteile der vorliegenden Vorrichtung 100 gemäß den Figuren 1 und 2 hingewiesen:

Der hier dargestellte Gunn-Oszillator 100 kann wie ein elektronisches Bauelement auf die H(och)F(requenz)-Schaltung bestückt werden, wobei die Spannungszuführung am Beinchen 54 des eingespritzten Metallteils 50 kontaktiert wird, während die Masse-Verbindung an der Stirnfläche des Oszillatorblocks 20 erfolgt. Hierbei werden beide Kontaktierungen in einem voll automatisierbaren Arbeitsgang hergestellt.

Zum Herstellen der elektrischen und mechanischen Verbindung kommen sowohl-SMD-Lötung als auch leitfähiges Kleben in Frage.

Der anhand des Ausführungsbeispiels gemäß den Figuren 1 und 2 dargelegte Aufbau des Gunn-Oszillators 100 bietet weiterhin den Vorteil, daß eventuell zusätzlich erforderliche Entstörkondensatoren sehr dicht am Gleichspannungs-Anschlußbeinchen 54 auf der H(och)F(requenz)-Schaltung mit untergebracht werden können. Hierdurch kann die in bekannten Oszillator-Ausführungen eingesetzte Zusatzleiterplatte dicht am Bias-Choke 16 entfallen.

## Patentansprüche

1. Vorrichtung (100) zum Erzeugen elektromagnetischer Schwingungen im Hoch Frequenz-Bereich mittels mindestens eines Gunn-Elements (10), *das in mindestens einen Hohlleiter* (22) *ragt, der in mindestens einem als Oszillatorblock fungierenden metallischen Grundkörper (20) eingebracht ist,*
- wobei die Vorrichtung (100) zum Anordnen auf mindestens einer leiterplattenartig ausgebildeten, sich im Wesentlichen planar erstreckenden elektrischen oder elektronischen Schaltungsanordnung ausgelegt ist,
- *wobei in mindestens einer Bohrung des Grundkörpers (20) mindestens eine spannungszuführende* Vorspannungs-Drossel *mit mindestens einer Resonatorscheibe sowie mit Hoch Frequenz-Filterstrukturen montiert ist,*
- wobei mindestens ein aus isolierendem Material gebildeter Kunststoffkörper (30) lateral in Bezug auf das Gunn-Element (10) am Grundkörper (20) angeordnet ist, wobei im Kunststoffkörper (30) mindestens ein aus metallisch leitfähigem Material gebildetes Verbindungselement (50) eingebracht ist, an *dessen einem Endbereich (52) eine eine Kraft auf die Vorspannungs-Drossel (16) ausübende und mithin eine Verbindung deie Vorspannungs-Drossel (16) mit dem Gunn-Element (10) bereit stellende Federstruktur (60) angeformt ist und*
*wobei der andere* Endbereich (54) des Verbindungselements (50) in Form mindestens einer Anschlussfläche ausgeformt und derart dimensioniert ist, dass die Anschlussfläche im Wesentlichen in einer Ebene mit der Austrittsfläche (24) des Hohlleiters (22) aus dem Grundkörper (20) liegt.

2. Vorrichtung gemäß Anspruch 1, **dadurch gekennzeichnet, dass** die Vorrichtung (100) in Form eines Surface Mounted Device-Bauelements auf der Schaltungsanordnung anbringbar ist.

3. Vorrichtung gemäß Anspruch 1 oder 2, **dadurch gekennzeichnet, dass** eine elektrische und/oder mechanische Verbindung zwischen der Vorrichtung (100) und der Schaltungsanordnung
- mittels leitfähigem Kleben und/oder
- mittels Surface Mounted Device-Löten
angeordnet ist.

4. Vorrichtung gemäß Anspruch 3, **dadurch gekennzeichnet, dass** die Austrittsfläche (24) des Hohlleiters (22) aus dem Grundkörper (20)
- mindestens eine Aussparung (80), die für den Durchtritt mindestens einer Hoch Frequenz-Leitung auf der im Wesentlichen planaren Schaltungsanordnung ausgelegt ist, und
- mindestens eine Nut (90), die für das Auffangen von überschüssigem Leitklebstoff bzw. von überschüssigem Surface Mounted Device-Lötmittel vorgesehen ist,
aufweist.

5. Vorrichtung gemäß mindestens einem der Ansprüche 1 bis 4, **dadurch gekennzeichnet, dass** das Gunn-Element (10) mit mindestens einer integrierten Wärmesenke (12) in mindestens eine *weitere* Bohrung des Grundkörpers (20) eingepasst und in dieser *weiteren* Bohrung mittels mindestens eines Verstemmelements (14) gegen Ausdrücken gesichert ist.

6. Einrichtung zum Erkennen oder adaptiven Regeln des Abstands eines Fortbewegungsmittels in Bezug auf mindestens ein Objekt, aufweisend mindestens eine Vorrichtung (100) gemäß mindestens einem der Ansprüche 1 bis 5, insbesondere ausgebildet als Fahrzeng-Radargerät,

## Claims

1. Apparatus (100) for generating electromagnetic oscillations in the high-frequency range by means of at least one Gunn element (10) which projects into at least one hollow conductor (22) which is made in at least one metal base body (20) which acts as an oscillator block,
- with the apparatus (100) being designed to be arranged on at least one electrical or electronics circuit arrangement which is formed in the manner of a printed circuit board and extends in a substantially planar manner,
- with at least one voltage-carrying bias choke (16) having at least one resonator disc and having high-frequency filter structures being mounted in at least one hole in the base body (20),
- with at least one plastic body (30) which is formed from insulating material being arranged on the base body (20) laterally in relation to the Gunn element (10),
with at least one connecting element (50), which is formed from metallically conductive material, being inserted in the plastic body (30), a spring structure (60) which exerts a force on the bias choke (16) and consequently provides a connection between the bias choke (16) and the Gunn element (10) being integrally formed at one end region (52) of the said connecting element, and
with the other end region (54) of the connecting element (50) being formed in the form at least of a connection area and being dimensioned in such a way that the connection area is situated substantially level with the exit area (24) of the hollow conductor (22) out of the base body (20).

2. Apparatus according to Claim 1, **characterized in that** the apparatus (100) can be mounted on the circuit arrangement in the form of a surface-mounted device component.

3. Apparatus according to Claim 1 or 2, **characterized in that** an electrical and/or mechanical connection is arranged between the apparatus (100) and the circuit arrangement
- by means of conductive adhesive bonding and/or
- by means of surface-mounted device soldering.

4. Apparatus according to Claim 3, **characterized in that** the exit area (24) of the hollow conductor (22) out of the base body (20) has
- at least one cutout (80) which is designed for the passage of at least one high-frequency line to the substantially planar circuit arrangement, and
- at least one groove (90) which is provided for collecting excess conductive adhesive or excess surface-mounted device soldering agent.

5. Apparatus according to at least one of Claims 1 to 4, **characterized in that** the Gunn element (10) having at least one integrated heat sink (12) is fitted into at least one further hole in the base body (20) and is secured, against being pushed out, in this further hole by means of at least one caulking element (14).

6. Device for identifying or adaptively controlling the distance of a means of transportation in relation to at least one object, having at least one apparatus (100) according to at least one of Claims 1 to 5, in particular in the form of a vehicle radar device.

## Revendications

1. Dispositif (100) pour générer des oscillations électromagnétiques dans la plage des hautes fréquences au moyen d'au moins un élément Gunn (10) qui fait saillie dans au moins un guide d'ondes (22), lequel est introduit dans au moins un corps de base (20) métallique faisant office de bloc oscillateur,
- le dispositif (100) étant conçu pour être disposé sur au moins un arrangement de circuit électrique ou électronique réalisé en forme de circuit imprimé et s'étendant pour l'essentiel de manière plane,
- au moins une bobine de polarisation (16) d'acheminement de la tension comprenant au moins un disque résonateur ainsi que des structures de filtre à haute fréquence étant montée dans au moins un alésage du corps de base (20),
- au moins un corps en matière plastique (30) formé en matériau isolant étant disposé latéralement sur le corps de base (20) par rapport à l'élément Gunn (10), au moins un élément de liaison (50) formé dans un matériau métallique conducteur étant introduit dans le corps en matière plastique (30), sur lequel est façonnée, au niveau d'une zone d'extrémité (52), une structure élastique (60) qui exerce une force sur la bobine de polarisation (16) et par conséquent réalise une liaison de la bobine de polarisation (16) avec l'élément Gunn (10) et
l'autre zone d'extrémité (54) de l'élément de liaison (50) étant réalisée sous la forme d'au moins une surface de raccordement et dimensionnée de telle sorte que la surface de raccordement se trouve pour l'essentiel dans un plan avec la surface de sortie (24) du guide d'ondes (22) hors du corps de base (20).

2. Dispositif selon la revendication 1, **caractérisé en ce que** le dispositif (100) peut être appliqué sur l'arrangement de circuit sous la forme d'un composant à montage en surface.

3. Dispositif selon la revendication 1 ou 2, **caractérisé en ce qu'**une liaison électrique et/ou mécanique est disposée entre le dispositif (100) et l'arrangement de circuit
- au moyen d'un adhésif conducteur et/ou
- au moyen d'une brasure pour composant à montage en surface.

4. Dispositif selon la revendication 3, **caractérisé en ce que** la surface de sortie (24) du guide d'ondes (22) hors du corps de base (20) présente
- au moins un évidement (80) qui est conçu pour le passage d'au moins une ligne à haute fréquence sur l'arrangement de circuit essentiellement plan et
- il est prévu au moins une rainure (90) pour accueillir la colle conductrice en excès ou le produit de brasage pour composant à montage en surface en excès.

5. Dispositif selon au moins l'une des revendications 1 à 4, **caractérisé en ce que** l'élément Gunn (10) muni d'au moins un dissipateur thermique (12) intégré est ajusté dans au moins un alésage supplémentaire du corps de base (20) et il est bloqué contre l'éjection dans cet alésage supplémentaire au moyen d'au moins un élément de matage (14).

6. Équipement pour détecter ou pour effectuer le réglage adaptatif de l'écart d'un moyen de déplacement par rapport à au moins un objet, présentant au moins un dispositif (100) selon au moins l'une des revendications 1 à 5, notamment réalisé sous la forme d'un appareil radar pour véhicule.
